Europäisches Patentamt

European Patent Office

Office européen des brevets

(11) Veröffentlichungsnummer: **0 189 520**
A1

(12) **EUROPÄISCHE PATENTANMELDUNG**

(21) Anmeldenummer: 85112025.3

(22) Anmeldetag: 23.09.85

(51) Int. Cl.⁴: **H 01 L 41/22**
G 10 K 11/18, B 32 B 18/00

(30) Priorität: 27.09.84 DE 3435569

(43) Veröffentlichungstag der Anmeldung:
**06.08.86** Patentblatt **86/32**

(84) Benannte Vertragsstaaten:
**DE FR GB IT NL SE**

(71) Anmelder: **Siemens Aktiengesellschaft Berlin und München**
**Wittelsbacherplatz 2**
**D-8000 München 2(DE)**

(72) Erfinder: **Mohaupt, Jutta**
**Theresienstrasse 54**
**D-8000 München 2(DE)**

(72) Erfinder: **Lubitz, Karl, Dr.**
**Röntgenstrasse 20**
**D-8012 Ottobrunn(DE)**

(72) Erfinder: **Schnöller, Manfred, Dr.**
**Grete-Hoffmann-Weg 4**
**D-8048 Haimhausen(DE)**

(72) Erfinder: **Wersing, Wolfram, Dipl.-Phys.**
**Weidenweg 14**
**D-8011 Kirchheim(DE)**

(54) Verfahren zur Herstellung einer Array-Ultraschall-Antenne.

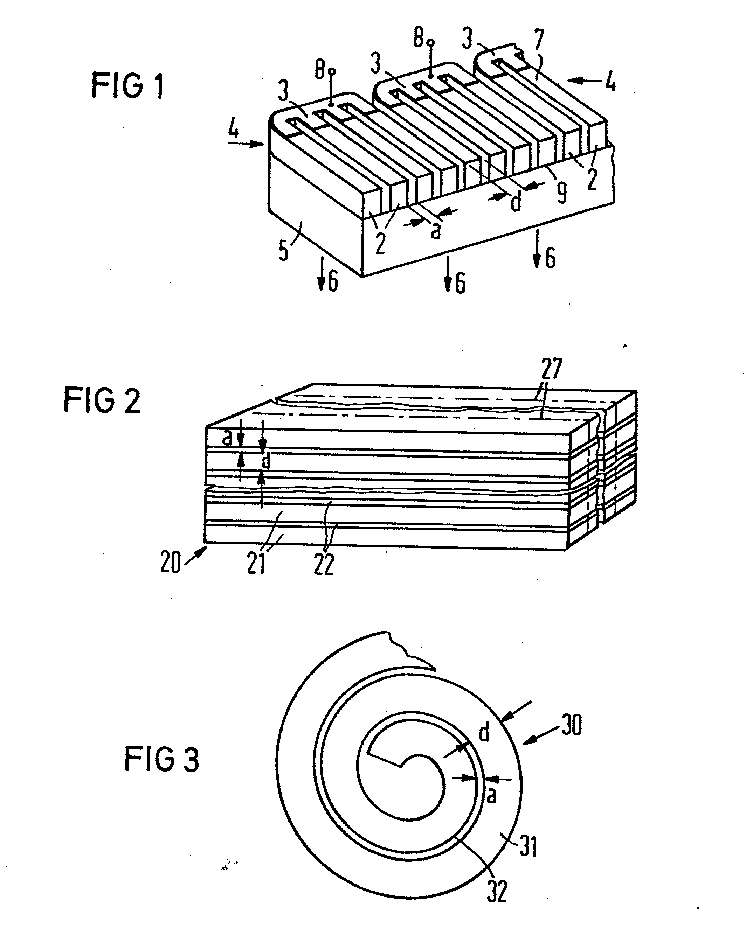

(57) Verfahren zur Herstellung einer linearen oder ringförmigen Array-Ultraschall-Antenne für den MHz-Bereich, wobei die Wandler (4) nach einem Stapelverfahren (Fig.2) hergestellt werden, bei dem abwechselnd Rohkeramikfolien (21) und Abstandsschichten (22) aufeinandergeschichtet werden, der Stapel (20) gesintert wird, wobei Füllmaterial aus den Abstandsschichten verschwindet, in den Abstandsschichten entstandene Hohlräume mit Kunststoff vergossen werden und der Stapel (20) in Scheiben gesägt (27) wird, die die Wandlerelemente (2) enthalten.

FIG 1

FIG 2

SIEMENS AKTIENGESELLSCHAFT
Berlin und München

Unser Zeichen 0189520
VPA 84 P 1790 E

## Verfahren zur Herstellung einer Array-Ultraschall-Antenne.

Die vorliegende Erfindung bezieht sich auf ein Verfahren
zur Herstellung einer Array-Ultraschall-Antenne, wie es
im Oberbegriff des Patentanspruchs 1 angegeben ist.

Es ist bekannt, für eine gerichtete Aussendung von Ultraschall als Antennen wirkende Sendewandler zu verwenden,
die als Array aus einer Anzahl Wandlerelemente besteht. Je
nach Einzelfall können diese Wandlerelemente in Phase oder
auch gegeneinander phasenverschoben mit der elektrischen
Anregungsspannung gespeist und zu Schwingungen angeregt werden. Entsprechendes gilt sinngemäß für den vorzugsweise gerichteten Empfang von Ultraschall-Strahlung mit einer derartigen Array-Anordnung, bei der die Empfangssignale der einzelnen Wandlerelemente in dem Einzelfall entsprechender Weise
superponiert werden.

Für den Bereich niedriger Frequenzen des Ultraschalls ist es
an sich unproblematisch, eine derartige Array-Antenne aus
den einzelnen Wandlerelementen aufzubauen. Schwierigkeiten
ergeben sich aber, wenn höhere Frequenzen, z.B. mehr als
1 MHz oder gar Frequenzen zwischen 5 und 10 MHz, verlangt
werden, weil die Größe der einzelnen in Resonanz zu betreibenden bzw. auf einer Eigenresonanz empfangenden Wandlerelemente sehr klein wird. Eine solche Antenne mit Linearanordnung hat z.B. 100 bis 200 Elemente, die z.B. auf eine
Anzahl jeweils elektrisch miteinander verbunden betriebener
Gruppen aufgeteilt sind.

Zur Herstellung einer derartigen Array-Antenne ist man von
Körpern, z.B. Platten aus fertig gesinterter Piezokeramik,

Bts 1 Bla / 21.8.1984

ausgegangen, die dann nachträglich mit einem Sägeverfahren
derart geschlitzt worden sind, daß sich einzelne Wandlerelemente ergeben, die das ganze Array bilden. Es sei darauf
hingewiesen, daß es auch Array-Antennen gibt, die Wandlerelemente besitzen, die im wesentlichen konzentrische Anordnung zueinander haben.

Aufgabe der vorliegenden Erfindung ist es, ein vereinfachtes Herstellungsverfahren für Array-Antennen anzugeben, die
für den MHz-Bereich bemessen sind.

Diese Aufgabe wird mit den Merkmalen des Patentanspruchs 1
gelöst. Weitere Ausgestaltungen und Weiterbildungen der Erfindung gehen aus den Unteransprüchen hervor.

Der Erfindung liegt der Gedanke zugrunde, daß für ein günstiges Herstellungsverfahren eines derartigen Arrays der Weg
einzuschlagen ist, die Herstellung der Keramik und die dem
Array entsprechende Formgebung in wenigstens weitgehend
integriertem Verfahrensablauf durchzuführen. Bei der vorliegenden Erfindung wird die Grundlage für die Form des Arrays
bereits vor Durchführung des Sinterprozesses gelegt, so daß
nach dem Sintern nur noch solche Bearbeitungsmaßnahmen erforderlich sind, die weniger aufwendig sind. Vor allem ist
bei der Erfindung nach dem Sintern keine solche Bearbeitungsmaßnahme - etwa vergleichsweise zum Stand der Technik -
vorgesehen, die zu größerem Ausschuß führen kann. Höhere
Ausschußrate ergibt sich z.B. beim Sägen feiner Strukturen.

Für das erfindungsgemäße Herstellungsverfahren ist von Maßnahmen ausgegangen worden, die in ähnlicher Weise bei der
Hestellung von keramischen Mehrschicht-Kondensatoren angewendet wird.

Weitere Erläuterungen der Erfindung werden anhand der Beschreibung zu den beigefügten Figuren gegeben.

Fig.1 zeigt ein erstes Ausführungsbeispiel einer nach der Erfindung hergestellten Antenne.

Fig.2 zeigt ein Zwischenstadium der Herstellung der Antenne.

Fig.3 zeigt ein zweites Ausführungsbeispiel einer nach der Erfindung hergestellten Antenne.

Fig.1 zeigt eine lineare Array-Antenne 1 mit nach der Erfindung hergestellten Wandlerelementen 2. Wie ersichtlich sind diese Wandlerelemente 2 langgestreckte quaderförmige Streifen aus Piezokeramik. Diese Wandlerelemente sind so angeordnet, daß die Abstände zwischen benachbarten Wandlerelementen 2 z.B. 0,07 mm und die in der gleichen Richtung gemessene Breite dieser Wandlerelemente beispielsweise 0,15 mm beträgt. Die Länge der einzelnen Wandlerelemente kann 10 bis 50 mm betragen; die Dicke beträgt beispielsweise das Doppelte bis Dreifache der Breitenabmessung.

Erfindungsgemäß geht die Herstellung der Wandlerelement-Anordnungen 4 bzw. der Wandlerelemente 2 wie nachfolgend beschrieben vor sich: Fig.2 zeigt hierzu einen Körper 20, der aus übereinanderliegend angeordneten Folien 21 aus (noch nicht gesinterter) Rohkeramik bzw. grüner Keramik zusammengesetzt ist. Die Abstände 22 der Folien 21 sind jeweilige Schichten aus einem Füllmaterial mit z.B. darin eingelagerten, den Abstand a haltenden Körnern. Das Füllmaterial ist ein (im Sinterprozeß) verbrennendes Material, z.B. Graphit. Als Abstandskörner ist vorzugsweise Zirkonoxid-, Magnesium- und/oder Aluminiumoxidpulver zu verwenden, und zwar solches mit einer engen Korngrößenverteilung. Das die Körner enthaltende Füllmaterial einer jeweiligen Abstandsschicht wird
z.B. nach einem Siebdruckverfahren auf vorgefertigte Rohkeramik-Folienstreifen 21 aufgedruckt, die dann als Stapel
20 aufeinandergelegt werden. Anstelle von Graphit eignet
sich auch Polyvenylalkohol.

Der Rohkörper nach Fig.2 wird nach einem derartigen Stapeln gesintert. Wegen der während des Sintervorganges angewendeten hohen Temperaturen verbrennt das Füllmaterial der
Abstandsschichten 22, so daß zwischen den Körnern Hohlräume entstehen, in denen sich noch die temperaturbeständigen Zirkonoxid- bzw. Aluminiumoxid-Körner befinden. Die
verbleibenden Körner geben eine mechanische Verbindung der
nunmehr gesinterten Folien 21 miteinander.

Die durch das Herausbrennen des Füllmaterials entstandenen
Hohlräume werden jetzt mittels eines Vakuum-Vergußverfahrens mit polymerisierendem, insbesondere aufblähendem
Kunststoffmaterial gefüllt. Ist ein schon polymerisiertes
Kunststoffmaterial für den Verguß zu dickflüssig, erfolgt
die Polymerisation erst nach dem Verguß. Gegebenenfalls vorgesehenes Aufblähen erfolgt nach dem Verguß. Das polymerisierte Vergußmaterial bildet eine mechanische Verbindung der
ursprünglichen Folienstreifen. Mit dem Aufblähen ist es
möglich, in dem gesinterten Keramikkörper, dessen Zwischenräume 22 mit dem Kunststoffmaterial (und mit den darin vorhandenen Körnern) gefüllt sind, diejenigen zunächst noch
bestehenden mechanischen Kontakte zu lösen bzw. zu lockern,
die über die Körner zwischen den im gesinterten Körper vorhandenen Zonen bestehen, die den ursprünglichen Rohkeramikfolien 21 entsprechen. Die Klebeeigenschaft des Kunststoffes
gewährleistet weiteren zuverlässigen Zusammenhalt. Geeignete
Kunststoffmaterialien sind: Polyurethan, Polystyrol, Polymethacrylate, Polymethylmethacrylate. Geeignete Blähmittel
sind Benzosulfonsäure , Hydrazine und Fluorchlormethanderivate.

Der vorhandene Kunststoff wirkt einem Zerbrechen entgegen.
Mit den Sägeschnitten 27 wird der gesinterte Stapel der
Fig.2 in Scheiben geschnitten, wie dies mit den Linien 27
angedeutet ist.  Es ergeben sich daraus solche Wandlerelement-Anordnungen 4, von denen eine in Fig.1 gezeigt ist.
Der vorhandene Kunststoff wirkt einem Zerbrechen entgegen.

Fig.3 zeigt eine Ausführungsform der Erfindung zur Herstellung einer Array-Antenne mit im wesentlichen ringförmigen
Wandlerelementen, genauer eine spiralförmige Array-Antenne.
Mit 31 ist eine Rohkeramik-Folie bezeichnet, die in Richtung
senkrecht zur Darstellung der Fig.3 lang ausgedehnt ist. Die
Fig.3 zeigt somit die Stirnseite eines aus einer solchen Rohkeramik bestehenden Wickels mit zwischen den einzelnen Windungen befindlichem Füllmaterial 32, das Abstandskörner enthält.  Zu diesem Füllmaterial und den Körnern gilt das zur
Fig. 2 Gesagte. Ein solcher aus vielen Windungen bestehender
Wickel nach Fig.3 wird gesintert und erhält so seine feste
Form.  Infolge des Herausbrennens des Füllmaterials 32 sind
zwischen den einzelnen Windungen des Wickels oben erörterte
Hohlräume vorhanden, wie sie die Zwischenräume 22 der Anordnung nach Fig.2 aufweisen.  Durch Sägeschnitte parallel
zur Ebene der Darstellung der Fig.3 werden die einzelnen als
jeweilige (Sende- und/oder Empfangs-)Antenne zu verwendenden
dünnen Wandlerspiralen 30 von dem Wickel nach Fig.3 abgetrennt.

Auch beim erfindungsgemäßen Verfahren sind Sägeschnitte erforderlich, jedoch keine solchen feinen Sägeschnitte, mit
denen die sehr geringen Abstände a (0,005 bis 0,02 mm) der
Wandlerelemente voneinander herzustellen wären.  Die bei der Erfindung erforderlichen Sägeschnitte sind auch deshalb unproblematisch, weil damit Dickenabmessungen von wenigstens
etwa 0,3 mm, vorzugsweise 0,5 bis 1 mm, hergestellt werden.

Die bei der Erfindung verwendeten Rohkeramik-Folien werden
nach an sich bekannten Folienzieh- oder -gießverfahren hergestellt, wobei man den Folien eine solche Dickenabmessung
gibt, die gleich der oben zur Fig.1 angegebenen Breite der
Wandlerelemente 2 ist.

Wie beschrieben entstehen mit dem Sintern des Keramikfolienstapels nach Fig.2 oder des Wickels nach Fig.3 Hohlräume
zwischen den Folien, nämlich durch Verbrennen und Zersetzen
des Füllmittels. Vorzugsweise vor dem Ausführen des Sägeschnittes 27 füllt man diese Hohlräume mit einem Kunststoffmaterial aus, das insbesondere mit einem Blähmittel versehen
ist. Als Blähmittel ist ein solches bevorzugt, das sich bei
einer Temperatur zersetzt, die deutlich über der Polymerisationstemperatur des Kunststoffes, jedoch hinreichend weit
unter seiner Zersetzungstemperatur, liegt. Statt der Hinzugabe eines Blähmittels kann auch ein solcher Kunststoff zum
Ausfüllen der Hohlräume vorgesehen sein, der bei teilweiser
Selbstzersetzung die Blähwirkung selbst erzeugt, und zwar
ohne seine Klebeeigenschaft wesentlich einzubüßen.

Zusätzlich zu den mit 27 bezeichneten Sägeschnitten kann
auch ein Schleifen als Nachbearbeitung vorgesehen sein.

Die zur Fig.1 bereits erwähnten Elektrodenbelegungen 7 können durch Aufsputtern aufgebracht sein. Die Polarisation
der Wandlerelemente 2 bzw. der Wandlerelement-Anordnung 4
oder der aus dem Wickel nach Fig.3 hergestellten Spiralantennen 30 erfolgt entsprechend an sich bekannter Maßnahmen, z.B. wird in Schutzgas (Schwefelhexafluorid) unter Einwirkung hoher elektrischer Spannung polarisiert.

Oben wurde erwähnt, daß die nach dem Sintern entstandenen
Hohlräume mit Kunststoff ausgefüllt werden. Diese Maßnahme
hat noch einen weiteren Vorteil, nämlich sie verhindert, daß
in der Wandlerelement-Anordnung 4 einander gegenüberliegende
Oberflächen der Wandlerelemente 2 beim Besputtern oder Bedampfen mit Elektrodenmaterial von diesem Elektrodenmaterial
mit bedeckt werden. Durch nachfolgendes Herauslösen des
Kunststoffes werden diese Zwischenräume wieder freigemacht,
wobei auf Oberflächen dieses Kunststoffes aufgebrachtes
Elektrodenmaterial mit entfernt wird. Es verbleiben dann
nur noch die Elektrodenbelegungen, die oben zum Array nach
Fig.1 angegeben sind.

Fig.1 zeigt mit 3 bezeichnete Elektrodenelemente, die am
jeweils einen Ende der Wandlerelemente 2 mit elektrischem
Kontakt mit den Elektroden 7 auf die Elemente 2 aufgebracht
sind. Mit diesen Elektrodenelementen 3 werden beim Beispiel
der Fig.1 jeweils vier benachbarte Wandlerelemente 2 der
Wandlerelement-Anordnung 4 elektrisch miteinander verbunden.
Mit 8 sind die jeweiligen Anschlußleitungen der Elektrodenelemente 3 bezeichnet. An die einzelnen Anschlüsse 8 können
nach vorzugebendem Muster die vorgesehenen Komponenten des
elektrischen Gesamtsignals angelegt werden, mit dem die jeweilige Array-Antenne zu speisen ist. Entsprechendes gilt
für die Verwendung der Antenne als Empfänger.

Die Anzahl der in einem Stapel 20 vorgesehenen Schichten
bzw. Folien 21 kann so groß gewählt sein, daß die durch Sägen 27 entstehenden Scheiben bereits die komplette Wandlerelement-Anordnung 4 ergeben. Es kann eine solche Anordnung 4
aber auch aus mehreren durch das Sägen 27 gewonnenen Teilen zusammengesetzt sein. Es wird dann ein Stapel 20 mit einer
sclchen Anzahl Schichten oder Folien 21 hergestellt, die
ganzzahlig vervielfacht die Gesamtanzahl der gewünschten
Wandlerelement-Anordnung 4 ergibt.

Patentansprüche:

1. Verfahren zur Herstellung einer Array-Ultraschall-
Antenne mit einer Wandleranordnung mit Nebeneinanderordnung von Wandlerelementen, wobei das Material dieser
Wandlerelemente Piezokeramik ist,
g e k e n n z e i c h n e t   dadurch ,
daß für Antennen für Ultraschall im MHz-Bereich
- zunächst ein Stapel (20) oder Wickel (30) hergestellt
  wird, der aus abwechselnd aufeinanderliegenden Keramikschichten (21, 31) und Abstandsschichten (22, 32)
  besteht, wobei die Keramikschichten (21, 31) aus noch
  nicht gesintertem Keramikmaterial bestehen und die Abstandsschichten ein Material ist, das aus einem in
  einem Sinterprozeß verbrennenden Füllmaterial und darin
  verteilten Metalloxidkörnern besteht, wobei die Größenklassierung der Körner der vorgesehenen Dicke der Abstandsschicht (22) entsprechend bemessen ist,
- daß der so hergestellte Stapel (20) oder Wickel (30)
  gesintert wird,
- daß ein Vakuumverguß-Verfahren angewendet wird, mit dem
  die durch das Herausbrennen des Füllmaterials in den Abstandsschichten (22, 32) zwischen den Metalloxidkörnern
  entstandenen Hohlräume mit einem polymerisierenden Kunststoff wenigstens weitgehend ausgefüllt werden, wobei zu
  einem gewissen Maß ein Miteinanderverkleben der nunmehr
  gesinterten Schichten (21, 31) über die jeweilige Abstandsschicht (22, 32) hinweg erreicht wird,
- daß der Stapel (20) oder der Wickel (30) durch quer zur
  Schichtung des Stapels (20) bzw. Wickels (30) in Abständen voneinander ausgeführten Sägeschnitten (27) in jeweilige Wandlerelement-Anordnungen (4 in Fig.1; Fig.3) zerteilt wird, und
- daß diese als Piezokeramik-Wandleranordnungen mit Elektroden versehen werden.

2. Verfahren nach Anspruch 1, g e k e n n z e i c h - n e t  dadurch, daß für das Material der Keramikschichten (21) Rohkeramikfolien hergestellt werden.

3. Verfahren nach Anspruch 2, g e k e n n z e i c h - n e t  dadurch, daß für einen Stapel (20) aus Rohkeramik- folie ausgestanzte Keramikfolienstreifen mit den Abmessungen der Stapel-Grundfläche entsprechenden Abmessungen verwendet werden.

4. Verfahren nach Anspruch 2, g e k e n n z e i c h - n e t  dadurch, daß aus der Rohkeramikfolie ein Wickel (30) hergestellt wird.

5. Verfahren nach Anspruch 3 oder 4, g e k e n n - z e i c h n e t  dadurch, daß vor dem Stapeln bzw. Wickeln die jeweilige Keramikfolie (21, 31) mit dem Material der Abstandsschichten (22, 32) bedruckt wird.

6. Verfahren nach einem der Ansprüche 1 bis 5, g e - k e n n z e i c h n e t  dadurch, daß Körner aus Zirkon-, Aluminium- und/oder Magnesiumoxid verwendet werden.

7. Verfahren nach einem der Ansprüche 1 bis 6, g e - k e n n z e i c h n e t  dadurch, daß eine blähbare Kunststoffmischung für den Verguß verwendet wird, wobei ein solches Blähmittel ausgewählt ist, dessen Blähtemperatur deutlich über der Polymerisationstemperatur des Kunststoffes, jedoch unterhalb dessen Versetzungstemperatur liegt.

8. Verfahren nach einem der Ansprüche 1 bis 7, g e - k e n n z e i c h n e t  dadurch, daß die gesägten (27) Scheiben auf einem den akustischen Zwecken entsprechenden Anpassungskörper (5) als Wandlerelement (4) aufgebracht werden (Fig.5)

9. Verfahren nach Anspruch 8, g e k e n n z e i c h - n e t  dadurch, daß der zwischen den Wandlerelementen (2) befindliche Kunststoff, vorzugsweise nach Aufbringen der Elektroden (7), wieder herausgelöst wird.

FIG 1

FIG 2

FIG 3

**Europäisches Patentamt**

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-1 474 369 (SECRETARY OF STATE FOR DEFENCE) <br> * Seite 1, Zeile 88 - Seite 2, Zeile 15 * | 1,2,4 | H 01 L 41/22 <br> G 10 K 11/18 <br> B 32 B 18/00 |
| A | EP-A-0 041 664 (SIEMENS) <br> * Seite 8, Zeile 30 - Seite 11, Zeile 3 * | 1 | |
| A | EP-A-0 051 535 (SOCIETE EUROPEENNE DE PROPULSION) <br> * Anspruch 1 * | 1 | |
| A,P | EP-A-0 137 529 (PHILIPS) <br> * Seite 4, Zeile 15 - Seite 5, Zeile 16 * | 1 | |

RECHERCHIERTE SACHGEBIETE (Int. Cl.4)

```
B 32 B    18/00
B 32 B    31/00
G 10 K    11/18
H 01 L    41/08
H 01 L    41/22
H 04 R    17/00
H 04 R    31/00
```

Der vorliegende Recherchenbericht wurde für alle Patentansprüche erstellt.

| Recherchenort | Abschlußdatum der Recherche | Prüfer |
|---|---|---|
| BERLIN | 30-01-1986 | GIBBS C.S. |